# EUROPÄISCHE PATENTSCHRIFT

(11) **EP 0 470 404 B1**
(45) Veröffentlichungstag und Bekanntmachung des Hinweises auf die Patenterteilung: **07.12.1994**
(21) Anmeldenummer: 91111846.1
(22) Anmeldetag: 16.07.1991
(51) Int. Cl.: H01R 13/41

(54) **Mehrpolige Steckvorrichtung**
Multipolar plug fixture
Arrangement pour fiche multipolaire

(30) Priorität: 07.08.1990 DE 4025049
(43) Veröffentlichungstag der Anmeldung: 12.02.1992
(73) Patentinhaber: SIEMENS AKTIENGESELLSCHAFT, 80333 München (DE)
(72) Erfinder: Koch, Georg, D-85716 Unterschleissheim (DE)

(56) Entgegenhaltungen:
- EP-A- 0 392 613
- FR-A- 1 456 937
- FR-A- 2 078 895
- US-A- 3 551 877

## Beschreibung

Die Erfindung bezieht sich auf eine mehrpolige Steckverbindung für elektrische Leitungsverbindungen zwischen Leiterplatten bzw. Leiterplatten und Aufnahmevorrichtungen eines Gerätes mit einer Steckverbinderleiste aus einem elektrisch isolierenden Trägerkörper und in diesen eingesetzten, abstandsparallel zueineander vorstehenden Pfosten bzw. Messer- oder Stiftkontakten.

Eine solche Steckvorrichtung ist beispielsweise durch die DE-A- 2 008 342 bekannt. Bei dieser sind die Pfosten bzw. Messer- oder Stiftkontakte jeweils zumindest mit dem Bereich des freien Endes im Schiebesitz durch eine zugeordnete, von entsprechend der Kontaktanordnung schablonenartig an wenigstens einer Fixierplatte aus Isoliermaterial angeordneten Durchsatzöffnungen hindurchgeführt und mit einer zumindest der Dicke der Fixierplatte zuzüglich des bestimmten Einschubbereichs entsprechenden freikragenden Länge ausgebildet. Die Pfosten bzw. Stiftkontakte sind über einen bestimmten Einsteckbereich ihrer freikragenden Länge in eine an einem weiteren elektrisch isolierenden Kontakt- bzw. Leitungsträger, beispielsweise der Trägerplatte einer gedruckten Schaltung, zugeordnete Öffnung einsteckbar.

Bei der Verbindungstechnik zwischen Leiterplatten bzw. Leiterplatten und externen Baugruppen durch Einlöten der Pfosten- bzw. Buchsenleisten in die Leiterplatten gibt es wärmetechnische Probleme, wenn das Löten nicht von Hand geschieht, indem die einzelnen Lötstellen nacheinander gelötet werden, sondern in einem automatischen Verfahren (z. B. Schwallöten, Reflowlöten). Bedingt durch die starke Erwärmung von Steckerkörper und Leiterplatte und deren unterschiedliche Ausdehnungskoeffizienten kommt es nach dem Erstarren des Lots zu starken mechanischen Spannungen, die zum Verbiegen der Leiterplatte führen.

Der Erfindung liegt die Aufgabe zugrunde, für eine in eine Leiterplatte einlötbare Steckverbinderleiste eine Lösung anzugeben, durch die ein Verbiegen der Leiterplatte vermieden wird.

Diese Aufgabe wird gemäß der Erfindung in der Weise gelöst, daß der Trägerkörper aus einem flachen, mäanderförmig ausgebildeten Teil besteht, in dessen zwischen den einzelnen Ausnehmungen benachbart zueinander liegenden Abschnitten die Kontaktelemente angeordnet sind.

Die Kontaktelemente können dabei senkrecht zur Ebene von Trägerkörper und Leiterplatte oder auch um 90° abgewinkelt, parallel zur Leiterplatte verlaufen entsprechend der Anordnung der zugehörigen Buchsenleiste.

Nachstehend wird die Erfindung anhand eines in der Zeichnung dargestellten Ausführungsbeispiels näher erläutert.

Es zeigen
- Fig. 1 und 2: einen in eine Leiterplatte eingelöteten starren Steckerkörper in einer Draufsicht und einer Seitenansicht und
- Fig. 3 und 4: einen in eine Leiterplatte eingelöteten, mäanderförmig ausgebildeten Steckerkörper in einer Draufsicht und einer Seitenansicht.

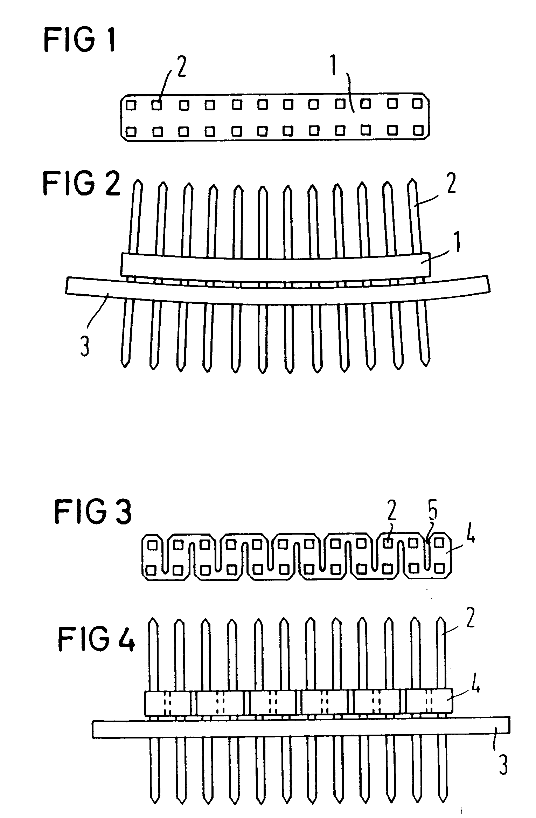

Fig. 1 und 2 zeigen einen starren Steckerkörper 1 herkömmlicher Bauart, in den die Kontaktstifte 2 eingesetzt sind. Der Steckerkörper 1 ist in eine Leiterplatte 3 eingelötet. Beim Abkühlen wird, bedingt durch unterschiedliche Schrumpfmasse, die Leiterplatte samt Stecker verbogen (vergl. Fig. 2).

Bei der erfindungsgemäßen Ausbildung ist vorgesehen, daß der Steckerkörper nicht mehr aus einem starren, kompakten Teil besteht, sondern mäanderförmig gestaltet ist. Ein solcher Trägerkörper 4 ist in Fig. 3 dargestellt, wobei die Stiftkontakte 2 in den jeweils benachbart zueinander liegenden Abschnitten angeordnet sind, die zwischen den durch die Mäanderform gebildeten Ausnehmungen 5 liegen. Beim Einlöten eines solchen Steckverbinders 2, 4 in eine Leiterplatte 3 treten trotz unterschiedlicher Schrumpfmasse beim Abkühlen keine Verbiegungen der Leiterplatte auf (vergl. Fig. 4). Ein solches mäanderförmiges bzw. faltenbalgähnliches Gebilde läßt sich in Längsrichtung ohne große Krafteinwirkung verformen, so daß durch unterschiedliche Längenänderung von Steckerkörper und Leiterplatte keine Kräfte entstehen, die zu einer unerwünschten Durchbiegung der Leiterplatte führen würden.

## Patentansprüche

1. Mehrpolige Steckvorrichtung für elektrische Leitungsverbindungen zwischen Leiterplatten (3) bzw. Leiterplatten und Aufnahmevorrichtungen eines Gerätes mit einer Steckverbinderleiste bestehend aus einem elektrisch isolierenden Trägerkörper (4) und in diesen eingesetzten, abstandsparallel zueinander vorstehenden Pfosten bzw. Messer-oder Stiftkontakten (2),
**dadurch** **gekennzeichnet**, daß der Trägerkörper (4) aus einem flachen, mäanderförmig ausgebildeten Teil besteht, in dessen zwischen den einzelnen Ausnehmungen (5) benachbart zueinander liegenden Abschnitten die Kontaktelemente (2) angeordnet sind.

2. Mehrpolige Steckvorrichtung nach Anspruch 1,
**dadurch** **gekennzeichnet**, daß die Kontaktelemente (2) senkrecht zur Ebene von Trägerkörper (4) und Leiterplatte (3) verlaufen.

3. Mehrpolige Steckvorrichtung nach Anspruch 1,
**dadurch** **gekennzeichnet**, daß die Kontaktelemente, um 90° abgewinkelt, parallel zur Leiterplatte verlaufen.

## Claims

1. Multipole plug device for electrical cable connections between printed circuit boards (3) or printed circuit boards and receiving devices of an appliance with a plug connector strip, comprising an electrically insulating support body (4) and, inserted therein, posts or male or pin contacts (2) which project parallel to and at a distance from each other, characterized in that the support body (4) comprises a flat part of meander-shaped design in whose sections, which are located adjacent to each other between the individual recesses (5), the contact elements (2) are arranged.

2. Multipole plug device according to Claim 1, characterized in that the contact elements (2) run perpendicular to the plane of the support body (4) and printed circuit board (3).

3. Multipole plug device according to Claim 1, characterized in that the contact elements, angled off by 90°, run parallel to the printed circuit board.

## Revendications

1. Dispositif de connexion multipolaire pour des connexions de lignes électriques entre les plaquettes à circuits imprimés (30) ou des plaquettes à circuits imprimés et des dispositifs de réception d'un appareil comportant une barrette de connecteur, constitué d'un corps de support (4) électriquement isolant et des broches ou des couteaux ou des tiges de contact (2), qui sont insérés dans ce corps et font saillie à distance les uns des autres et parallèlement les uns aux autres,
caractérisé par le fait que le corps de support (4) est constitué d'une pièce plate, de forme sinueuse, dans laquelle les éléments de contact (2) sont disposés entre les évidements (5) de parties voisines.

2. Dispositif de connexion multipolaire selon la revendication 1, caractérisé par le fait que les éléments de contact (2) sont perpendiculaires au plan du corps de support (4) et de la plaquette à circuits imprimés (3).

3. Dispositif de connexion multipolaire selon la revendication 1, caractérisé par le fait que les éléments de contact, qui sont coudés à 90°, s'étendent parallèlement à la plaquette à circuits imprimés.
